# EUROPÄISCHE PATENTSCHRIFT

(11) **EP 2 127 508 B1**
(45) Veröffentlichungstag und Bekanntmachung des Hinweises auf die Patenterteilung: **26.06.2013**
(21) Anmeldenummer: 07847875.7
(22) Anmeldetag: 06.12.2007
(51) Int. Cl.: H05K 3/32

(54) **ELEKTRISCHE KONTAKTIERVORRICHTUNG, INSBESONDERE FÜR ELEKTRONISCHE SCHALTUNGEN, UND ELEKTRISCHE/ELEKTRONISCHE SCHALTUNG**
ELECTRIC CONTACTING DEVICE, PARTICULARLY FOR ELECTRONIC CIRCUITS, AND ELECTRIC/ELECTRONIC CIRCUIT
DISPOSITIF DE MISE EN CONTACT ÉLECTRIQUE, NOTAMMENT POUR DES CIRCUITS ÉLECTRONIQUES, ET CIRCUIT ÉLECTRIQUE/ÉLECTRONIQUE

(30) Priorität: 28.12.2006 DE 102006062485
(43) Veröffentlichungstag der Anmeldung: 02.12.2009
(73) Patentinhaber: Robert Bosch GmbH, 70442 Stuttgart (DE)
(72) Erfinder: KIMMICH, Peter, 71101 Schoeneich (DE)
(86) Internationale Anmeldenummer: PCT/EP2007/063387
(87) Internationale Veröffentlichungsnummer: WO 2008/080749

(56) Entgegenhaltungen:
- DE-A1- 19 833 131
- JP-A- 1 084 787
- JP-A- 9 064 505
- JP-A- 11 087 876
- US-B1- 6 486 410

## Beschreibung

Die Erfindung betrifft eine elektrische Kontaktiervorrichtung, insbesondere für elektronische Schaltungen, mit einem elektrisch nicht leitenden Substrat, auf dem mindestens ein elektrisch leitfähiges Kontaktelement angeordnet ist.

Ferner betrifft die Erfindung eine elektrische/elektronische Schaltung.

### Stand der Technik

Elektrische Kontaktiervorrichtungen der eingangs genannten Art sind weitgehend bekannt. So gibt es Leiterplatten (PCB = printed circuit board), die elektrisch leitende Leiterbahnen aufweisen, die auf einem elektrisch nicht leitenden Substrat angeordnet sind. Zur Kontaktierung von elektrischen/elektronischen Bauteilen werden letztere mit den Leiterbahnen der Leiterplatte durch beispielweise Bonden, Leitkleben, Schweißen, kalte Kontaktiertechniken wie Schneidklemmverbindungen oder Krempen, Stecken oder Löten (elektrisch) verbunden.

Bonden und Schweißen sind serielle Prozesse. Das bedeutet, dass eine Bondbeziehungsweise Schweißverbindung nach der anderen hergestellt werden muss, wodurch die Herstellungs- beziehungsweise Prozesskosten hoch und die Taktzeiten bei der Herstellung lang ausfallen. Darüber hinaus müssen spezielle Bond- oder Schweißautomaten vorhanden sein oder angeschafft werden.

Das Herstellen von mehreren Lötverbindungen gleichzeitig, beispielsweise mit einem Schwallbad, benötigt teure Ofenprozesse und kann bei unterschiedlichen Substraten und/oder unterschiedlichen vorausgegangenen Prozessen oft nicht oder nur unter großen Schwierigkeiten eingesetzt werden.

Unter kalten Kontaktiertechniken sind mechanische Verbindungen, wie zum Beispiel Federkontakte, Krempen oder Schneidklemmverbindungen, zu verstehen. Derartige Kontaktiervorrichtungen sind nur bedingt miniaturisierbar und erfordern eine hohe Präzision bei der Fertigung sowie entsprechend hohe Werkzeugkosten.

Bekannte Leitkleber, die auf das Substrat aufgebracht werden, besitzen eine beschränkte Stromübertragungsfähigkeit und benötigen zum Befestigen ebenfalls teure Ofenprozesse.

Weiterhin sind Leitgummi-Kontaktiervorrichtungen bekannt, wie zum Beispiel Zebragummi, eingezogene Fäden (LCD) oder "board-to-board"-Kontaktierungen, die jedoch nur von oben nach unten kontaktieren, also nur zwischen zwei auf gegenüberliegendenden Seiten eines Substrats angeordneten elektrischen/elektronischen Bauteilen eine elektrische Verbindung realisieren. Darüber hinaus weisen derartige Leitgummikontaktierungen einen schlechten Übergangswiderstand auf. Eine Schaltung mit einer Berührungskontaktvorrichtung auf einem elastisch verformbaren Substrat ist aus DE 19833131 A1 bekannt.

### Offenbarung der Erfindung

Die Erfindung betrifft eine elektrische/elektronische Schaltung mit mindestens zwei elektrisch zu verbindenden elektrischen/elektronischen Bauteilen und mit einer elektrischen Kontaktvorrichtung wie In Anspruch 1 offenbart.

Ferner ist vorgesehen, dass die elektrische Kontaktiervorrichtung als Berührungskontaktiervorrichtung ausgebildet ist, wobei das Substrat zum Aufbringen eines Kontaktierdrucks aus elastisch nachgiebigem Material gebildet ist oder dieses aufweist. Vorteilhafterweise ist das Substrat also aus einem elastisch nachgiebigem Material gebildet oder weist dieses auf, sodass bei einem Berührungskontakt des elektrisch leitfähigen Kontaktelements, welches auf dem Substrat angeordnet ist, mit einem oder mehreren zu kontaktierenden Gegenkontaktelementen eines elektrischen/elektronischen Bauteils das Substrat vorzugsweise im Bereich des Kontaktelements elastisch nachgibt. Ist zum Beispiel die elektrische Kontaktiervorrichtung in einem Gehäuseteil und das zu kontaktierende elektrische/elektronische Bauteil in einer anderen Gehäuseteil einer elektronischen Schaltung angeordnet, so wird beim Zusammenfügen der beiden Gehäuseteile automatisch eine dauerhafte elektrische Verbindung zwischen dem Kontaktelement und dem elektrischen/elektronischen Bauteil dadurch erstellt, dass das elektrische/elektronische Bauteil auf das Kontaktelement gedrückt wird, wodurch dieses aufgrund des elastisch nachgiebigen Substrats zurückgedrängt wird. Wobei aufgrund der Elastizität des Substrats ein das Kontaktelement gegen das elektrische/elektronische Bauteil drückender Kontaktierdruck erzeugt wird. Durch diese vorteilhafte Ausgestaltung der Kontaktiervorrichtung ist es möglich, auf einfache Art und Weise eine sichere elektrische Verbindung mittels eines Berührungskontaktes dauerhaft herzustellen, wobei fertigungsbedingte Fertigungs- und/oder Lagetoleranzen von zu kontaktierenden Bauteilen automatisch ausgeglichen werden. Die vorteilhafte Kontaktiervorrichtung bildet dabei eine kalte Kontaktiertechnik, die eine einfache und schnelle Montage beziehungsweise Kontaktierung mehrerer elektrischer/elektronischer Bauteile ermöglicht.

Vorteilhafterweise ist das Kontaktelement derart ausgebildet, das eine elektrische Verbindung in der Ebene des Substrats herstellbar ist. Es ist also vorgesehen, dass beispielsweise eine elektrische Verbindung zwischen zwei elektrischen/elektronischen Bauteilen, die nebeneinander auf einer Seite des Substrats angeordnet sind, mittels des Kontaktelements herstellbar ist. Es ist also vorteilhafterweise eine elektrische Verbindung von "links nach rechts" in einer Ebene herstellbar.

Zweckmäßigerweise ist das Kontaktelement als eine Leiterbahn ausgebildet. Diese ist zweckmäßigerweise so auf dem Substrat angeordnet, dass eine gewünschte elektrische Verbindung hergestellt werden kann.

Nach einer Weiterbildung der Erfindung sind mehrere, eine Leiterbahnstruktur bildende Kontaktelemente auf dem Substrat angeordnet. Dadurch werden komplexe Schaltungen möglich, die auf einfache Art und Weise, gemäß der erfindungsgemäßen Ausbildung, durch Berührungskontakt elektrische Verbindungen herstellen können. Dabei werden die elektrischen/elektronischen Bauteile einer Schaltung vorteilhafterweise in entsprechende Aufnahmen eines Gehäuseteils eingelegt, sodass sie in diesem Gehäuseteil ausgerichtet sind. Anschließend wird die erfindungsgemäße elektrische Kontaktiervorrichtung aufgelegt, wobei diese vorteilhafterweise Zentriermittel, wie zum Beispiel Zentrierstifte oder Aussparungen, aufweist, die ein Ausrichten der elektrischen Kontaktiervorrichtung in dem Gehäuseteil ermöglichen. Auch kann die elektrische Kontaktiervorrichtung beziehungsweise das Substrat selbst eine Form und/oder Außenkontur aufweisen, die es in dem Gehäuseteil ausrichtet. Anschließend wird durch ein Gegenstück, wie zum Beispiel ein Gehäusedeckel, der eine geeignete Formgebung aufweist und dadurch vorteilhafterweise partiell oder flächig auf die Rückseite der elektrischen Kontaktiervorrichtung aufliegt, die Kontaktiervorrichtung gegen die elektrischen/elektronischen Bauteile. Durch das Drücken des Gehäusedeckels gegen die Kontaktiervorrichtung beziehungsweise das Gehäuseteil werden die Kontaktelemente beziehungsweise die Leiterbahnstruktur auf die entsprechenden Gegenkontakte der elektrischen/elektronischen Bauteile gedrückt. Die Druckkraft kann dabei mittels Haken, Klipsen, Federn oder auch durch Schrauben dauerhaft gewährleistet werden. Da das Substrat, wie oben beschrieben, aus einem elastisch nachgiebigem Material besteht und dadurch beim Aufbringen der Druckkraft im Bereich des jeweiligen Kontaktelements beziehungsweise Kontaktpunkts mit einem elektrischen/elektronischen Bauteil elastisch nachgibt, wird eine sichere elektrische Verbindung zu jedem einzelnen Gegenkontakt der elektrischen/elektronischen Bauteile gewährleistet, da Fertigungs- und/oder Lagetoleranzen ausgeglichen werden.

Nach einer Weiterbildung der Erfindung sind das Kontaktelement oder die Leiterbahnstruktur von einer strukturierten Metallfolie gebildet. So wird zum Beispiel zur Herstellung des Kontaktelements/der Leiterbahnstruktur eine elektrisch leitende Metallfolie auf das Substrat gelegt und anschließend durch Ätzen strukturiert. Alternativ kann die Leiterbahnstruktur auch durch Stanzen, Heißprägen oder andere abtragende, dem Fachmann bekannte Fertigungsverfahren hergestellt werden, sodass einzelne, voneinander getrennte elektrisch leitende Flächen entstehen, die als Leiterbahnen Verwendung finden. Zum Schutz vor Korrosion weist die verwendete Folie vorteilhafterweise eine Edelmetalloberfläche oder eine andere dem Fachmann bekannte chemisch inaktive Oberfläche auf.

Nach einer Weiterbildung der Erfindung wird das Kontaktelement oder die Leiterbahnstruktur vorteilhafterweise von einer elektrisch leitenden auf das Substrat aufgebrachten Druckschicht gebildet. Dabei wird zum Beispiel in einem Siebdruckverfahren ein Karbon-Leitlack oder Metall-gefüllte Farbe auf das Substrat aufgebracht, wobei die Leiterbahnstruktur aufgrund der Formgebung des verwendeten Siebs erzeugt wird. Weiterhin ist denkbar, dass das Substrat eine bestimmte "dreidimensionale" Form aufweist, also nicht eben ausgebildet ist. Zum Beispiel kann das Substrat rechtwinklig ausgebildet sein, wodurch die auf dem Substrat angeordneten Kontaktelemente in zwei Ebenen senkrecht zueinander angeordnet sind.

Nach einer Weiterbildung der Erfindung ist die elektrische Kontaktiervorrichtung als Kontaktiermatte ausgebildet. Das bedeutet, dass die Kontaktiervorrichtung ein im Wesentliches leicht verformbares, flexibles Element darstellt, wodurch die Kontaktiervorrichtung nicht nur in einer Ebene verwendet werden kann. Befinden sich zum Beispiel die Kontakte der zu Kontaktierenden elektrischen/elektronischen Bauteile in zwei unterschiedlichen Ebenen, sind sie zum Beispiel senkrecht oder schief zueinander angeordnet, so kann die Kontaktiermatte entsprechend gelegt beziehungsweise geformt werden, sodass in beiden Ebenen ein Berührungskontakt möglich ist. Dabei können die unterschiedlichen Ebenen sowohl nebeneinander als auch direkt übereinander angeordnet sein. Abgesehen von der einfachen Handhabung ergibt sich durch die flexible Ausbildung der Kontaktiervorrichtung als Kontaktmatte sich ein weiterer wesentlicher Vorteil in Bezug auf den Ausgleich von Fertigungs- und/oder Lagetoleranzen. Vorteilhafterweise ist das Substrat aus einem Elastomer-Material gebildet oder weist dieses auf.

Erfindungsgemäβ bildet das Substrat mindestens eine Dichtung. Aufgrund des elastisch nachgiebigen Materials kann das Substrat derart in einem Gehäuse angeordnet werden, dass es als Dichtung zwischen zwei Gehäuseteilen wirkt. Vorteilhafterweise weist das Substrat dazu mindestens einen Dichtvorsprung auf, der bevorzugt in eine Vertiefung des Gehäuses eingreift, um eine besonders wirkungsvolle Dichtung zu ermöglichen.

Die erfindungsgemäße elektrische/elektronische Schaltung weist mindestens zwei elektrische/elektronische Bauteile auf, die durch eine vorstehend beschriebene Kontaktiervorrichtung miteinander elektrisch verbunden sind. Dabei ermöglicht das elastisch nachgiebige Material der Kontaktiervorrichtung, wie oben beschrieben, einen vorteilhaften Ausgleich von Fertigungs- und/oder Lagetoleranzen der elektrischen/elektronischen Bauteile sowie der diese Bauteile aufnehmenden Gehäuseteile der elektronischen Schaltung.

Nach einer Weiterbildung der Erfindung sind die Bauteile dabei auf einer Seite des Substrats angeordnet, sodass eine elektrische Verbindung, wie oben beschrieben, von "links nach rechts" in einer Ebene hergestellt wird.

Erfindungsgemäβ ist die Kontaktiervorrichtung zwischen zwei Gehäuseteilen der elektronischen Schaltung eingeklemmt, sodass zum einen ein Druck auf die Kontaktiervorrichtung ausgeübt wird, der ihre Kontaktelemente gegen die entsprechenden Gegenkontakte der elektrischen/elektronischen Bauteile drückt, und zum anderen die Kontaktiervorrichtung beziehungsweise das elastisch nachgiebige Substrat der Kontaktiervorrichtung als Dichtmittel genutzt wird.

### Kurze Beschreibung der Zeichnungen

Im Folgenden soll die Erfindung anhand einiger Figuren näher erläutert werden. Dazu zeigen:
- Figur 1: ein Ausführungsbeispiel einer erfindungsgemäßen Kontaktiervorrichtung und
- Figur 2: ein Ausführungsbeispiel einer elektronischen Schaltung mit einer erfindungsgemäßen Kontaktiervorrichtung.

### Ausführungsform(en) der Erfindung

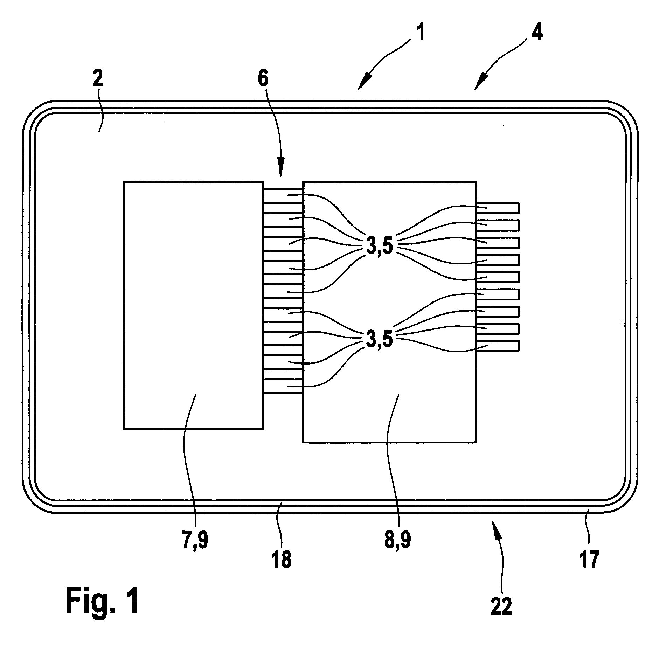

Die Figur 1 zeigt in einer Draufsicht ein Ausführungsbeispiel einer erfindungsgemäßen elektrischen Kontaktiervorrichtung 1. Die Kontaktiervorrichtung 1 weist ein im Wesentlichen rechteckförmiges Substrat 2 auf, auf dem mehrere Kontaktelemente 3 angeordnet sind. Die Kontaktiervorrichtung 1 ist dabei als Berührungskontaktiervorrichtung 4 ausgebildet, sodass die Kontaktelemente 3 als Berührungskontakte wirken. Das Substrat 2 ist in dem vorliegenden Ausführungsbeispiel aus einem elastisch nachgiebigen Material gebildet, sodass wenn ein Druck auf die Kontaktelemente 3, senkrecht zur Papierebene, ausgeübt wird, diese zurückgedrängt werden beziehungsweise das Substrat elastisch nachgibt und somit die Kontaktelemente in das Material des Substrats 2 eingedrückt werden. Dadurch wird eine sichere und dauerhafte elektrische Verbindung zu einem, beziehungsweise jedem, damit zu kontaktierenden elektrischen/elektronischen Bauteil beziehungsweise des zu kontaktierenden Gegenkontakts des Bauteils realisiert, wobei Fertigungs- und/oder Lagetoleranzen ausgeglichen werden.

Die in der Figur 1 dargestellten Kontaktelemente 3 bilden jeweils eine kurze Leiterbahn 5, die zur elektrischen Verbindung von zwei elektrischen/elektronischen Bauteilen dient, welche in einer Ebene nebeneinander angeordnet sind, wobei jeweils ein Gegenkontaktelement von zwei Bauteilen mit einem Kontaktelement 3 beziehungsweise einer Leiterbahn 5 in Berührungskontakt gebracht wird und somit die Bauteile elektrisch miteinander verbunden werden. Durch das elastisch nachgiebige Material des Substrats 2 wird dabei der notwendige Kontaktierdruck für eine sichere und dauerhafte elektrische Verbindung gewährleistet. Die Kontaktelemente 3 bilden in dem vorliegenden Ausführungsbeispiel eine einfach gestaltete Leiterbahnstruktur 6. Natürlich sind aber auch kompliziertere Leiterbahnstrukturen für komplexe elektronische Schaltungen denkbar.

Die Kontaktelemente 3 können beispielsweise aus einer Metallfolie, beispielsweise einer Kupfer-Folie, hergestellt werden und durch Ätzvorgänge, Stanzen, Heißprägen oder andere dem Fachmann bekannte abtragende Fertigungsverfahren strukturiert werden, sodass die einzelnen Kontaktelemente 3 beziehungsweise voneinander getrennte Flächen entstehen, die die Leiterbahnen 5 bilden. Zum Schutz vor Korrosion weist die Metallfolie vorteilhafterweise eine Edelmetalloberfläche oder eine andere chemisch inaktive Oberfläche auf. Dabei können die Metallfolie beziehungsweise die Kontaktelemente 3 auf dem Substrat verklebt oder durch einen Beschichtungsvorgang damit verbunden werden. Alternativ dazu können die Kontaktelemente 3 auch mittels eines Siebdruckverfahrens erstellt werden, wobei beispielsweise Karbon-Leitlack oder Metall-gefüllte Farbe auf das elektrisch nicht leitende Substrat 2 aufgebracht wird. Das Substrat 2 selbst besteht vorteilhafterweise aus einem Elastomer-Material, welches elektrisch nicht leitend ist. Die dargestellte Kontaktiervorrichtung 1 weist darüber hinaus zwei Aussparungen 7 und 8 auf, die beispielsweise zum Durchführen von elektrischen/elektronischen Bauteilen oder Gehäuseteilen oder zur Kühlung dienen. Auch können die Aussparungen 7, 8 als Zentriermittel 9 derart gestaltet sein, dass sie zum Ausrichten beziehungsweise Zentrieren der Kontaktiervorrichtung 1 in einem Gehäuse dienen.

Mittels der vorteilhaften Kontaktiervorrichtung 1 ist es möglich, zu mehreren elektrischen/elektronischen Bauteilen gleichzeitig auf einfache Art und Weise eine elektrische Verbindung sicher und dauerhaft herzustellen, wobei die Platzierung von elektrischen/elektronischen Bauteilen räumlich wesentlich flexibler gestaltet werden kann, wodurch sich auch Vorteile in der elektromagnetischen Verträglichkeit (EMV) ergeben. Durch die Berührungskontaktierung wird ein wirkungsvoller paralleler Montage- und Fügeprozess ermöglicht, wobei Fertigungs- und/oder Lagetoleranzen vorteilhaft ausgeglichen werden.

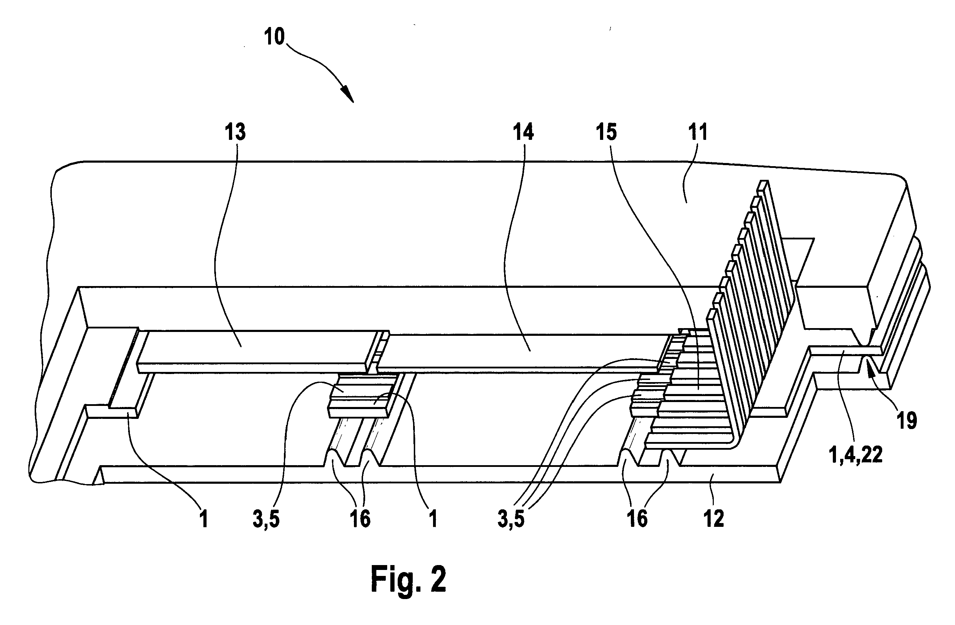

Die Figur 2 zeigt in einer perspektivischen Darstellung ein Ausführungsbeispiel einer vorteilhaften elektronischen Schaltung 10, die ein Gehäuseteil 11 und einen Gehäusedeckel 12 aufweist. Die in der Figur 2 dargestellte elektronische Schaltung 10 ist dabei von schräg unten gezeigt. Zwischen dem Gehäuseteil 11 und dem Gehäusedeckel 12 ist die aus der Figur 1 bekannte Kontaktiervorrichtung 1 sowie ein erstes elektrisches/elektronisches Bauteil 13 und ein zweites elektrisches/elektronisches Bauteil 14 und ein aus dem Gehäuseteil 11 herausführendes Stanzgitter 15 angeordnet. Die Bauteile 13 und 14 sowie das Stanzgitter 15 liegen dabei mit entsprechenden Gegenkontakten auf den Kontaktelementen 3 der Kontaktiervorrichtung 1 beziehungsweise der Berührungskontaktiervorrichtung 4 auf. In dem dargestellten Ausführungsbeispiel ist das Bauteil 13 als LTCC (Low-Temperature-Cofired-Ceramic = Niedertemperatur-Einbrand-Keramik) und das Bauteil 14 als DBC-Bauteil (Direct-Bonded-Copper-Bauteil) ausgebildet. Vorteilhafterweise werden das Gehäuseteil 11 und der Gehäusedeckel 12 durch Verschrauben miteinander verbunden, wobei das Gehäuseteil 11 und der Gehäusedeckel 12 gegeneinander gedrückt werden. Dabei weist der Gehäusedeckel 12 im Bereich der Kontaktelemente 3 der Kontaktiervorrichtung 1 Vorsprünge 16 auf, die die Kontaktiervorrichtung 1 beziehungsweise das Substrat 2 gegen die Bauteile 13, 14 und das Gehäuseteil 11 drücken, wodurch der Berührungskontakt realisiert wird. Durch die elastische Ausbildung des Substrats 2 wird dabei für jede elektrische Verbindung ein Kontaktierdruck erbracht, der den sicheren und dauerhaften Berührungskontakt gewährleistet, wobei, wie bereits gesagt, Fertigungs- und/oder Lagertoleranzen ausgeglichen werden.

Bei der Montage der elektronischen Schaltung 10 werden zunächst die Bauteile 13, 14 und das Stanzgitter 15 in Aufnahmen des Gehäuseteils 11 eingelegt. Durch eine geeignete Formgebung der Aufnahmen im Gehäuseteil 11 sind die Bauteile 13, 14 beziehungsweise das Stanzgitter 15 mit ausreichender Genauigkeit räumlich fixiert. Anschließend wird die Berührungskontaktiervorrichtung 4 beziehungsweise Kontaktiervorrichtung 1 aufgelegt. Durch ihre Formgebung, wie zum Beispiel durch die Zentriermittel 9, wird die Kontaktiervorrichtung 1 beziehungsweise die Berührungskontaktiervorrichtung 4 in die richtige Position für eine sichere Berührungskontaktierung der Bauteile 13, 14 beziehungsweise Stanzteile 15 gebracht. Abschließend wird der Gehäusedeckel 12 auf die Kontaktiervorrichtung 1 beziehungsweise Berührungskontaktiervorrichtung 4 gedrückt. Dadurch wird die notwendige Kontaktkraft für den elektrischen Berührungskontakt eingeleitet. Die notwendige Druckkraft kann durch Klipse, Haken, Federn oder auch durch Schrauben, wie bereits gesagt, dauerhaft gehalten werden.

Wie in der Figur 1 dargestellt, weist die Kontaktiervorrichtung 1 an ihrem Randbereich 17 einen sich über den gesamten Umfang erstreckenden Dichtvorsprung 18 auf. Der Dichtvorsprung 18 ist wulstartig ausgebildet und wird beim Zusammenfügen des Gehäuseteils 11 mit dem Gehäusedeckel 12 zwischen diesen beiden eingeklemmt, sodass eine Dichtung 19 gebildet wird. Alternativ oder zusätzlich dazu können auch das Gehäuseteil 11 und der Gehäusedeckel jeweils einen Dichtvorsprung 20, 21 aufweisen, zwischen denen das Substrat 2 eingeklemmt wird. Aufgrund des elastisch nachgiebigen Materials wird dabei in beiden Fällen eine sichere Dichtung 19 realisiert.

Auch kann das Substrat 2 derart geformt sein, dass die Kontaktelemente 3 in unterschiedlichen Ebenen, beispielsweise parallel oder in einem Winkel zu einander angeordnet sind.

Vorteilhafterweise ist die Kontaktiervorrichtung 1 beziehungsweise Berührungskontaktiervorrichtung 4 als Kontaktmatte 22 ausgebildet, die flexibel verformbar ist. So können auch Bauteile der elektronischen Schaltung 10, die in einer anderen Ebene parallel oder schräg zur Ebene der der Bauteile 13, 14 liegen, mittels der gleichen Kontaktiervorrichtung auf einfache Art und Weise kontaktiert werden, ohne dass die Form des Substrates vorher angepasst werden muss, wodurch Fertigungs- und/oder Lagetoleranzen vorteilhaft ausgeglichen und die Montage erleichtert wird.

## Patentansprüche

1. Elektrische/elektronische Schaltung mit mindestens zwei elektrisch zu verbindenden elektrischen/elektronischen Bauteilen, mit einer elektrischen Kontaktvorrichtung (1), die ein elektrisch nicht leitendes Substrat (2), auf dem mindestens ein elektrisch leitfähiges Kontaktelement (3) angeordnet ist, aufweist, wobei die Kontaktiervorrichtung (1) als Berührungskontaktiervorrichtung (4) ausgebildet ist, und das Substrat (2) zum Aufbringen eines Kontaktierdrucks aus elastisch nachgiebigem Material gebildet ist oder dieses aufweist, **dadurch gekennzeichnet, dass** das Substrat eine Dichtung (19) bildet und hierzu einen sich über den gesamten Umfang erstreckenden Dichtvorsprung (18) aufweist, der zwischen einem Gehäuseteil (11) und einem Gehäusedeckel (12) der Schaltung eingeklemmt ist.

2. Elektrische/elektronische Schaltung nach Anspruch 1, **dadurch gekennzeichnet, dass** das Kontaktelement (3) derart ausgebildet ist, dass eine elektrische Verbindung in der Ebene des Substrats (2) herstellbar ist.

3. Elektrische/elektronische Schaltung nach einem der vorhergehenden Ansprüche, **dadurch gekennzeichnet, dass** das Kontaktelement (3) als eine Leiterbahn (5) ausgebildet ist.

4. Elektrische/elektronische Schaltung nach einem der vorhergehenden Ansprüche, **dadurch gekennzeichnet, dass** mehrere eine Leiterbahnstruktur (6) bildende Kontaktelemente (3) auf dem Substrat (2) angeordnet sind.

5. Elektrische/elektronische Schaltung nach einem der vorhergehenden Ansprüche, **dadurch gekennzeichnet, dass** das Kontaktelement (3) oder die Leiterbahnstruktur (6) von einer strukturierten Metallfolie gebildet sind.

6. Elektrische/elektronische Schaltung nach einem der vorhergehenden Ansprüche, **dadurch gekennzeichnet, dass** das Kontaktelement (3) oder die Leiterbahnstruktur (6) von einer elektrisch leitenden, auf das Substrat (2) aufgebrachten Druckschicht gebildet sind.

7. Elektrische/elektronische Schaltung nach einem der vorhergehenden Ansprüche, **dadurch gekennzeichnet, dass** die Kontaktiervorrichtung (1) als Kontaktmatte (22) ausgebildet ist.

8. Elektrische/elektronische Schaltung nach einem der vorhergehenden Ansprüche, **dadurch gekennzeichnet, dass** das Substrat (2) Zentriermittel (9) aufweist.

9. Elektrische/elektronische Schaltung nach einem der vorhergehenden Ansprüche, **dadurch gekennzeichnet, dass** das Substrat (2) aus einem Elastomer-Material gebildet ist oder dieses aufweist.

10. Elektrische/elektronische Schaltung nach einem der vorhergehenden Ansprüche, **dadurch gekennzeichnet, dass** das Substrat (2) mindestens einen Dichtvorsprung (18) aufweist.

11. Elektrische/elektronische Schaltung nach Anspruch 1, **dadurch gekennzeichnet, dass** die Bauteile (13,14) auf einer Seite der Kontaktiervorrichtung (1) angeordnet sind.

12. Elektrische/elektronische Schaltung nach einem der Ansprüche 1 oder 11 , **dadurch gekennzeichnet, dass** die Kontaktiervorrichtung (1) zwischen einem Gehäuseteil (11) und einem Gehäusedeckel (12) geklemmt ist.

## Claims

1. Electrical/electronic circuit having at least two electrical/electronic components which are to be electrically connected, having an electrical contact apparatus (1) which has an electrically non-conductive substrate (2) on which at least one electrically conductive contact element (3) is arranged, wherein the contact-making apparatus (1) is in the form of a touch contact-making apparatus (4), and the substrate (2) is formed from or comprises elastically flexible material for the purpose of applying a contact-making pressure, **characterized in that** the substrate forms a seal (19) and, to this end, has a sealing projection (18) which extends over the entire circumference and which is clamped-in between a housing part (11) and a housing cover (12) of the circuit.

2. Electrical/electronic circuit according to Claim 1, **characterized in that** the contact element (3) is formed in such a way that an electrical connection can be established in the plane of the substrate (2).

3. Electrical/electronic circuit according to either of the preceding claims, **characterized in that** the contact element (3) is in the form of a conductor track (5).

4. Electrical/electronic circuit according to one of the preceding claims, **characterized in that** a plurality of contact elements (3), which form a conductor track structure (6), are arranged on the substrate (2).

5. Electrical/electronic circuit according to one of the preceding claims, **characterized in that** the contact element (3) or the conductor track structure (6) is formed by a structured metal foil.

6. Electrical/electronic circuit according to one of the preceding claims, **characterized in that** the contact element (3) or the conductor track structure (6) is formed by an electrically conductive printed layer which is applied to the substrate (2).

7. Electrical/electronic circuit according to one of the preceding claims, **characterized in that** the contact-making apparatus (1) is in the form of a contact mat (22).

8. Electrical/electronic circuit according to one of the preceding claims, **characterized in that** the substrate (2) has centring means (9).

9. Electrical/electronic circuit according to one of the preceding claims, **characterized in that** the substrate (2) is formed from or comprises an elastomeric material.

10. Electrical/electronic circuit according to one of the preceding claims, **characterized in that** the substrate (2) has at least one sealing projection (18).

11. Electrical/electronic circuit according to Claim 1, **characterized in that** the components (13, 14) are arranged on one side of the contact-making apparatus (1).

12. Electrical/electronic circuit according to either of Claims 1 and 11, **characterized in that** the contact-making apparatus (1) is clamped between a housing part (11) and a housing cover (12).

## Revendications

1. Circuit électrique/électronique doté d'au moins deux composants électriques/électroniques à relier sur le plan électrique, avec un dispositif de contact électrique (1) comportant un substrat (2) électriquement non conducteur sur lequel est disposé au moins un élément de contact électriquement conducteur (3), le dispositif de mise en contact (1) prenant la forme d'un dispositif de mise en contact par effleurement (4) et le substrat (2) étant formé à partir d'une matière flexible sur le plan élastique ou comportant de cette matière pour appliquer une pression de mise en contact, **caractérisé en ce que** le substrat forme un joint (19) et comporte pour ce faire une saillie étanche (18) s'étendant sur la totalité de la périphérie et engoncée entre une partie de carter (11) et un cache de carter (12) du circuit.

2. Circuit électrique/électronique selon la revendication 1, **caractérisé en ce que** l'élément de contact (3) est réalisé de façon à permettre la mise en place d'une liaison électrique dans le plan du substrat (2).

3. Circuit électrique/électronique selon l'une quelconque des revendications précédentes, **caractérisé en ce que** l'élément de contact (3) prend la forme d'une piste conductrice (5).

4. Circuit électrique/électronique selon l'une quelconque des revendications précédentes, **caractérisé en ce que** plusieurs éléments de contact (3) formant une structure de piste conductrice (6) sont disposés sur le substrat (2).

5. Circuit électrique/électronique selon l'une quelconque des revendications précédentes, **caractérisé en ce que** l'élément de contact (3) ou la structure de piste conductrice (6) est formé par un film en métal structuré.

6. Circuit électrique/électronique selon l'une quelconque des revendications précédentes, **caractérisé en ce que** l'élément de contact (3) ou la structure de piste conductrice (6) est formé par une couche de pression électriquement conductrice appliquée sur le substrat (2).

7. Circuit électrique/électronique selon l'une quelconque des revendications précédentes, **caractérisé en ce que** le dispositif de mise en contact (1) prend la forme d'une natte de contact (22).

8. Circuit électrique/électronique selon l'une quelconque des revendications précédentes, **caractérisé en ce que** le substrat (2) comporte des moyens de centrage (9).

9. Circuit électrique/électronique selon l'une quelconque des revendications précédentes, **caractérisé en ce que** le substrat (2) est constitué à partir d'une matière élastomère ou comporte de cette matière.

10. Circuit électrique/électronique selon l'une quelconque des revendications précédentes, **caractérisé en ce que** le substrat (2) comporte au moins une saillie étanche (18).

11. Circuit électrique/électronique selon la revendication 1, **caractérisé en ce que** les composants (13, 14) sont disposés sur un côté du dispositif de mise en contact (1).

12. Circuit électrique/électronique selon l'une quelconque des revendications 1 ou 11, **caractérisé en ce que** le dispositif de mise en contact (1) est coincé entre une partie de carter (11) et un cache de carter (12).
